# EUROPEAN PATENT SPECIFICATION

(11) **EP 0 618 671 B1**
(45) Date of publication and mention of the grant of the patent: **23.07.1997**
(21) Application number: 94850037.6
(22) Date of filing: 15.03.1994
(51) Int. Cl.: H03B 23/00

(54) **Arrangement for generating a continuous frequency sweep**
Vorrichtung zur Erzeugung einer kontinuierlichen Frequenzablenkung
Dispositif pour la génération d'un balayage de fréquence continue

(30) Priority: 01.04.1993 SE 9301081
(43) Date of publication of application: 05.10.1994
(73) Proprietor: TELIA AB, 126 86 Farsta (SE)
(72) Inventor: Nordin, Sven, 136 41 Haninge (SE)
(74) Representative: Karlsson, Berne

(56) References cited:
- GB-A- 1 211 905
- PATENT ABSTRACTS OF JAPAN vol. 5, no. 153 (E-76) (825) 26 September 1981 & JP-A-56 084 002 (FUJITSU K.K.) 9 July 1981
- PATENT ABSTRACTS OF JAPAN vol. 13, no. 525 (E-850) 22 November 1989 & JP-A-01 215 124 (YOKOGAWA ELECTRIC CORP) 29 August 1989
- ELECTRONIC ENGINEERING, vol.59, no.723, March 1987, LONDON GB pages 103 - 111 GUY PURCHON AND TIM PEGG: 'The digital control-architecture of a microwave sweeper'

## Description

### Field of the invention

The present invention relates to an arrangement for generating a continuous frequency sweep. To be able to perform a continuous frequency sweep over a number of octaves, an oscillator is needed which can sweep a large range without interruption. This technique is needed inter alia for being able to measure transmission parameters in a microwave band. The present invention specifies an arrangement which uses oscillators which are coupled together and which, together, form a continuous frequency sweep.

### Prior art

It has previously been known to couple together voltage-controlled oscillators in order to produce in this manner a wide sweep. Each oscillator has its frequency interval and the oscillators are coupled one after the other in turn. The oscillators are controlled at voltage intervals which are generated by sawtooth generators. Switching from one oscillator to the next has previously been carried out by using the end of the sweep voltage interval as criterion for shifting to the next oscillator.

Due to the fact that the oscillators partially overlap one another's range, a notch occurs in the frequency sweep. The oscillators are also temperature-dependent, as a result of which control over the frequency at switch-over is even worse. Naturally, it is desirable to have as even a frequency curve as possible.

Arrangements in which switching-over from one oscillator to the next is carried out, whereby control is performed in dependence upon the phase difference between adjacent oscillators are known from JP-A-56-84002 and JP-A-1-215124.

### Summary of the invention

According to the present invention as defined in the appended claims, the end of the frequency of each oscillator is used instead as switch-over criterion, which provides a continuous sweep without interruption.

The arrangement according to the invention thus comprises a frequency detector coupled to each neighbouring pair of oscillators for detecting when the first oscillator in the pair has reached the same frequency as the second oscillator in the pair. The frequency detector then generates a switch-over signal for the respective sawtooth generators and control units so that the first oscillator is disconnected from the output and the second oscillator is connected to the output at the same time as the second oscillator frequency begins to be swept.

### Brief description of the drawings

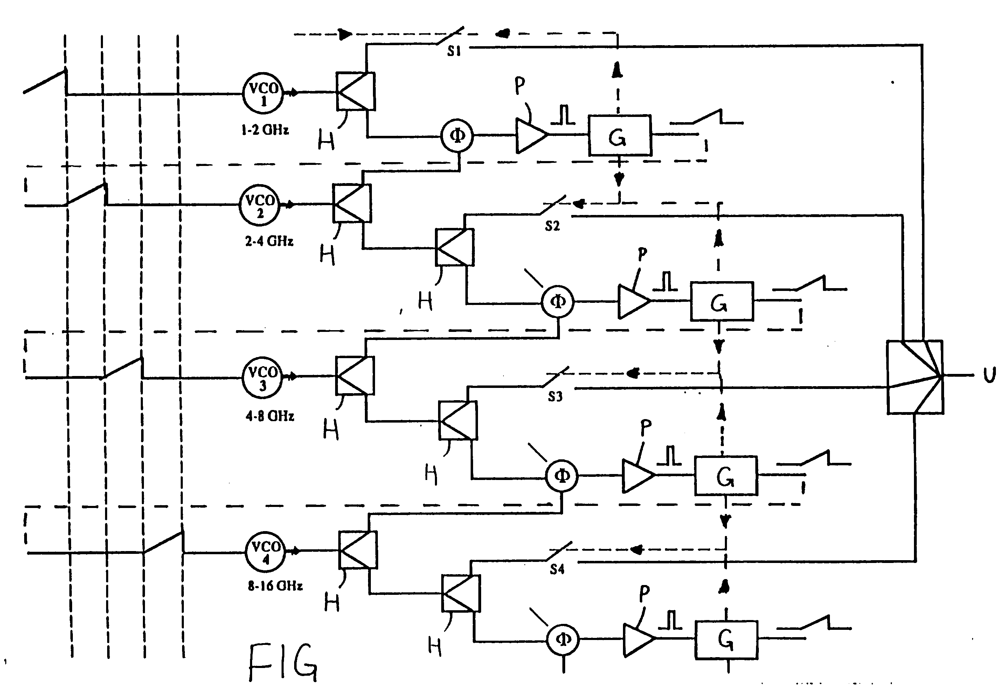

The invention will now be described in detail with reference to the following drawing, in which the single figure is a block diagram of an embodiment of the invention.

### Detailed description of a preferred embodiment

In the figure, an arrangement for producing a frequency sweep from 1-16 GHz with the aid of four voltage-controlled oscillators VCO 1-4 is described. The oscillators are controlled with sawtooth voltages such as shown on the left in the figure. The voltage can go, for example, from 0-5 volts. Thus, for example, VCO 1 has the frequency 1 GHz at 0 volt and 2 GHz at 5 volts. The oscillators, however, are not completely stable and the frequency normally also varies slightly with temperature. At 5 volts, the frequency from VCO 1 is thus not precisely 2 GHz but normally slightly higher. In the same way, the frequency from VCO 2 is not precisely 2 GHz at 0 volt voltage but normally slightly lower. Switching thus from VCO 1 to VCO 2 when the voltage is 5 volts at VCO 1 and 0 volt at VCO 2, a notch occurs in the frequency curve. It is this problem which the present invention intends to solve.

To continue with the figure, the oscillators VCO 1-4 are coupled together with the aid of hybrid circuits H. From each oscillator, a signal goes via respective switches S1-S4 to a common output U. The switches S1-S4 are controlled as will be described below.

Between each pair of neighbouring oscillators, that is to say VC1 and VC2, VC2 and VC3 and so forth, a frequency detector Φ is connected. After each frequency detector there is a pulse shaper P and a unit G which contains sawtooth generators and switch control. There is normally also an amplifier (not shown) at the output U for producing an even amplitude from the arrangement.

The operation of the arrangement is as follows, with a sweep from 1-16 GHz. All oscillators VCO 1-4 are fed from the beginning with their own low voltages. The switch S1 is closed and the sweep of the oscillator VCO 1 starts automatically or by manual command. VCO 1 receives its sawtooth voltage from a sawtooth generator, not shown. When the frequency from VCO 1 coincides with the frequency from VCO 2, that is to say at the upper cut-off frequency for VCO 1 and the lower cut-off frequency for VCO 2, 2 GHz, the frequency detector Φ generates a pulse at its output. The pulse is shaped in the pulse shaper 1 which triggers the unit G. The switch S1 is thus opened and the switch S2 is closed and the sweep of VCO 2 is started in the sawtooth generator.

Switch-over to VCO 3 and VCO 4 occurs in corresponding manner, which can be easily seen. Naturally, the arrangement can contain more than four oscillators, which is indicated in the figure. When the last oscillator has been swept, the arrangement is reset and a new sweep can be started. This occurs manually or automatically in certain applications.

The arrangement is thus provided with a continuous-frequency sweep. If the frequency detector Φ is also phase-sensitive, a continous-phase sweep can also be obtained. The phase/frequency detector Φ then provides a signal when both frequency and phase agree. Using components currently available, the frequency detector Φ and pulse shaper P can be made so fast that a very even sweep is obtained.

The invention is used in a connection in which wide frequency sweep ranges are needed. It is possible to name, for example, spectrum analyzers, measuring instruments and oscilloscopes. A special field is the investigation of reflections at microwave both indoors and outdoors. The reflections have previously been studied using each frequency by itself. Using the invention, a quick sweep can be performed over the entire current range and all necessary information can be obtained in this manner. The invention can also be used for checking transmission functions of wide-band amplifiers in optical technology.

The scope of the invention is limited only by the claims below.

## Claims

1. Arrangement for generating a continuous frequency sweep comprising a number of voltage-controlled oscillators (VCO 1-4), each having its own frequency interval, which, together, can form a contiguous frequency interval, switches (S1-S4) for connecting a respective oscillator (VCO 1-4) to a common output (U), a respective sawtooth generator (G) linked to each oscillator (VCO 1-4) and a respective control unit linked to each switch (S1-S4), characterized in that a frequency detector (Φ) is connected to each pair of oscillators (VCO 1-4) having a neighbouring frequency intervall, for detecting when the first oscillator in the pair has reached the same frequency as the second oscillator in the pair and then generating a switch-over signal to respective sawtooth generators (G) and control units so that the first oscillator is disconnected from the output (U) and the second oscillator is connected to the output (U) at the same time as the frequency of the second oscillator begins to be swept.

2. Arrangement according to Claim 1, characterized in that each frequency detector is also phase-sensitive, the switch-over signal being generated when the output signals from the first and second oscillator have the same frequency and phase.

## Patentansprüche

1. Anordnung zum Erzeugen einer kontinuierlichen Frequenzüberstreichung, die eine Anzahl von spannungsgesteuerten Oszillatoren (VCO 1-4), wobei jeder sein eigenes Frequenz-intervall hat, die zusammen ein aneinanderstoßendes Frequenzintervall bilden können, Schalter (S1-S4) zum Verbinden eines entsprechenden Oszillators (VCO 1-4) mit einem gemeinsamen Ausgang (U), einen entsprechenden Sägezahngenerator (G), der mit jedem Oszillator (VCO 1-4) verbunden ist, und eine entsprechende Steuereinheit aufweist, die mit jedem Schalter (S1-S4) verbunden ist, dadurch gekennzeichnet, daß ein Frequenzdetektor (Φ) mit jedem Paar von Oszillatoren (VCO 1-4), die ein benachbartes Frequenzintervall haben, verbunden ist, um festzustellen, wenn der erste Oszillator in dem Paar dieselbe Frequenz wie der zweite Oszillator in dem Paar erreicht hat, und um dann ein Umschaltsignal zu entsprechenden Sägezahngeneratoren (G) und Steuereinheiten zu erzeugen, so daß der erste Oszillator vom Ausgang (U) getrennt und der zweite Oszillator mit dem Ausgang (U) verbunden wird zu der gleichen Zeit, wie die Überstreichung mit der Frequenz des zweiten Oszillators beginnt.

2. Anordnung nach Anspruch 1, dadurch gekennzeichnet, daß jeder Frequenzdetektor auch phasenempfindlich ist, wobei das Umschaltsignal erzeugt wird, wenn die Ausgangssignale von den ersten und zweiten Oszillatoren dieselbe Frequenz und Phase aufweisen.

## Revendications

1. Dispositif pour la génération d'un balayage de fréquence continue comprenant un certain nombre d'oscillateurs commandés en tension (VCO 1 à 4), chacun ayant son propre intervalle de fréquence, qui ensemble, peuvent former un intervalle de fréquence continue, des commutateurs (S1 à S4) pour connecter un oscillateur respectif (VCO 1 à 4) à une sortie commune (U), un générateur à base de temps (G) respectif relié à chaque oscillateur (VCO 1 à 4) et une unité de commande respective reliée à chaque commutateur (S1 à S4), caractérisé en ce qu'un détecteur de fréquence (Φ) est relié à chaque paire d'oscillateurs (VCO 1 à 4) ayant un intervalle de fréquence voisin pour détecter le moment où le premier oscillateur de la paire a atteint la même fréquence que le second oscillateur de la paire et alors générer un signal de basculement vers les générateurs à base de temps respectifs (G) et les unités de commande de sorte que le premier oscillateur est déconnecté de la sortie (U) et le second oscillateur est relié à la sortie (U) au même moment où la fréquence du second oscillateur commence à être balayée.

2. Dispositif selon la revendication 1, caractérisé en ce que chaque détecteur de fréquence est également sensible à la phase, le signal de basculement étant généré lorsque les signaux de sortie provenant des premier et second oscillateurs ont les mêmes fréquence et phase.
